# EUROPÄISCHE PATENTANMELDUNG

(11) **EP 4 242 401 A1**
(43) Veröffentlichungstag der Anmeldung: **13.09.2023**
(21) Anmeldenummer: 23160711.0
(22) Anmeldetag: 08.03.2023
(51) Int. Cl.: E05B 81/76, E05B 17/10, H03K 17/97, H03K 17/955

(54) **MODULBAUTEIL FÜR EIN BEWEGLICHES TEIL EINES FAHRZEUGES UND EIN VERFAHREN ZUM HERSTELLEN EINES MODULBAUTEILS**

(30) Priorität: 09.03.2022 DE 102022105504
(71) Anmelder: Huf Hülsbeck & Fürst GmbH & Co. KG, 42551 Velbert (DE)
(72) Erfinder: Bott, Ingo, 40625 Düsseldorf (DE); Hohler, Dirk, 40885 Ratingen (DE); Beck, Andreas, 44795 Bochum (DE); Knubben, Florian, 45277 Essen (DE); Hoffmann, Andreas, 42489 Wülfrath (DE)
(74) Vertreter: Bals & Vogel Patentanwälte PartGmbB

(57) **Zusammenfassung**

Die Erfindung betrifft ein Modulbauteil (100) für ein bewegliches Teil (201) eines Fahrzeuges (200), aufweisend:
- ein Trägergehäuse (10) zum Befestigen des Modulbauteils (100) am beweglichen Teil (201) des Fahrzeuges (200),
- eine Tasteneinheit (20) zum Betätigen des beweglichen Teils (201) des Fahrzeuges (200),
wobei die Tasteneinheit (20) eine Tastenkappe (21) aufweist, die dazu ausgeführt ist, eine Aktivierungshandlung, insbesondere eine Berührung und/oder Kraftausübung, eines Benutzers aufnehmen zu können,
wobei an der Tastenkappe (21) zwei Aktivierungselemente (24) angeordnet sind, um die Aktivierungshandlung des Benutzers erfassen zu können,

- und eine Elektronikeinheit (30) zum Bereitstellen von Sensorfunktionen beim Betätigen des beweglichen Teils (201) des Fahrzeuges (200),
wobei die Elektronikeinheit (30) am Trägergehäuse (10) befestigt ist,
und wobei die Elektronikeinheit (30) eine induktive Sensoreinheit (31) für eine Aktivierungshandlungserfassung an der Tasteneinheit (20) aufweist.

## Beschreibung

Die Erfindung betrifft ein Modulbauteil für ein bewegliches Teil, wie z. B. eine Tür oder eine Klappe, eines Fahrzeuges, bspw. in Form einer Betätigungseinheit für einen feststehenden Griff, eine Griffmulde oder eine Außenhaut des beweglichen Teils oder für ein zum beweglichen Teil angrenzendes Bauteil des Fahrzeuges, nach dem Oberbegriff des unabhängigen Vorrichtungsanspruches, wobei das Modulbauteil zum Betätigen des beweglichen Teils ausgeführt ist. Weiter betrifft die Erfindung ein Verfahren zum Herstellen eines Modulbauteils nach dem Oberbegriff des unabhängigen Verfahrensanspruches.

Es ist aus dem Stand der Technik bekannt, dass Sensoreinheiten in den Griffen oder in den Griffmulden integriert werden, um eine berührungslose Betätigung von beweglichen Teilen des Fahrzeuges zu ermöglichen. Die berührungslose Betätigung kann einem berechtigten Benutzer erlaubt sein. Um die Berechtigung des Benutzers zu überprüfen, kann ein Sicherheitssystem des Fahrzeuges einen ID-Code (Identifikationscode) abfragen. Auch kann es möglich sein, dass eine Betätigung eines beweglichen Teils erst nach einem Erfassen einer Annäherung eines Benutzers zum beweglichen Teil und nach einem Erfassen einer Aktivierungshandlung des Benutzers an einem Taster einer Sensoreinheit erfolgt. Eine Aktivierungshandlung wird in manchen Sensoreinheiten durch induktive Sensoren detektiert. Manche Sensoreinheiten weisen zudem Leuchteinheiten auf, um in einer schlechtbeleuchteten Umgebung das Auffinden von Tastern zu erleichtern.

Es hat sich als Nachteil herausgestellt, dass die Funktionsweise von bekannten Sensoreinheiten, bspw. durch fehlerhafte Kontaktierung von Sensorelementen, eingeschränkt sein kann und oft nicht über die erforderliche Lebenszeit von Sensoreinheiten, wie vorgesehen, gewährleistet werden kann. Das mechanische Befestigen und das elektrische Verschalten von Sensorelementen innerhalb der bekannten Sensoreinheiten gestalten sich ebenfalls als aufwendig und auf Dauer nicht zuverlässig.

Aufgabe der Erfindung ist, die voranstehend beschriebenen Nachteile zumindest zum Teil zu überwinden. Ferner ist es Aufgabe der Erfindung, ein verbessertes Modulbauteil für ein bewegliches Teil, wie z. B. eine Tür oder eine Klappe, eines Fahrzeuges bereitzustellen, vorzugsweise in Form einer Betätigungseinheit für einen feststehenden Griff, eine Griffmulde, bspw. bei einem grifflosen beweglichen Teil, und/oder eine Außenhaut des beweglichen Teils und/oder ein zum beweglichen Teil angrenzendes Bauteil des Fahrzeuges, wie z. B. eine Fahrzeug-Säule, bereitzustellen. Insbesondere ist es Aufgabe der Erfindung, ein verbessertes Modulbauteil zum Betätigen eines beweglichen Teils eines Fahrzeuges zur Verfügung zu stellen, welches erweiterte, verbesserte Funktionen einer einfachen, intuitiven und komfortablen Benutzung sowie Erkennbarkeit der Modulbauteil zuverlässig ermöglicht und welches eine verlängerte Einsatzdauer aufweist. Bevorzugt ist es Aufgabe der Erfindung, ein verbessertes Modulbauteil zum Betätigen eines beweglichen Teils eines Fahrzeuges bereitzustellen, welches einfach und kostengünstig hergestellt und aufgebaut werden kann, welches einfach gehandhabt und einfach montiert werden kann, welches einfach verschaltet werden kann. Ferner ist es Aufgabe der Erfindung, ein verbessertes Verfahren zum Herstellen eines entsprechenden Modulbauteils bereitzustellen. Die voranstehende Aufgabe wird gelöst durch ein Modulbauteil für ein bewegliches Teil mit den Merkmalen des unabhängigen Vorrichtungsanspruches und durch ein Verfahren zum Herstellen eines solchen Modulbauteils mit den Merkmalen des unabhängigen Verfahrensanspruches. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Modulbauteil beschrieben sind, selbstverständlich auch im Zusammenhang mit dem erfindungsgemäßen Verfahren und jeweils umgekehrt, so dass bzgl. der Offenbarung zu den einzelnen Erfindungsaspekten stets wechselseitig Bezug genommen wird bzw. werden kann.

Die Aufgabe wird insbesondere gelöst durch ein Modulbauteil für ein bewegliches Teil eines Fahrzeuges,
aufweisend:
- ein Trägergehäuse zum Befestigen des Modulbauteils am beweglichen Teil des Fahrzeuges, wie z. B. an einem feststehenden Griff, einer Griffmulde und/oder einer Außenhaut des beweglichen Teils und/oder an einem zum beweglichen Teil angrenzenden Bauteil des Fahrzeuges,
- eine Tasteneinheit zum Betätigen des beweglichen Teils des Fahrzeuges,
   wobei die Tasteneinheit eine Tastenkappe aufweist, die dazu ausgeführt ist, eine Aktivierungshandlung, insbesondere eine Berührung und/oder Kraftausübung, eines Benutzers aufnehmen zu können,
   und wobei an der Tastenkappe (mindestens) zwei (oder mehrere), insbesondere symmetrisch an der Tastenkappe verteilte, Aktivierungselemente angeordnet sind, um die Aktivierungshandlung des Benutzers erfassen zu können,
- und eine Elektronikeinheit zum Bereitstellen von Sensorfunktionen beim Betätigen des beweglichen Teils des Fahrzeuges,
   wobei die Elektronikeinheit am Trägergehäuse befestigt ist,
   und wobei die Elektronikeinheit eine induktive Sensoreinheit für eine Aktivierungshandlungserfassung an der Tasteneinheit aufweist.

Die Erfindung erkennt die Problematik der eingeschränkten Funktionsweise von Sensoreinheiten in Verbindung mit betätigbaren, bspw. bewegbaren und/oder verformbaren Tasteinheiten. Um die Problematik zu beheben, schlägt die Erfindung ein kombiniertes Modulbauteil vor, welches mit folgenden Elementen ausgebildet ist:
- einer modular ausgestalteten Elektronikeinheit, die eine funktionstechnisch sowie verschaltungstechnisch integrierte induktive Sensoreinheit, ggf. eine funktionstechnisch sowie verschaltungstechnisch integrierte kapazitive Sensoreinheit, und optional eine funktionstechnisch sowie verschaltungstechnisch integrierte Beleuchtungseinheit, aufweist; -
- einer Tasteneinheit, die derart, bspw. verformbar, aufgeführt sein kann und/oder die mindestens einen verformbaren Deformationsbereich aufweisen kann, und die mindestens zwei Aktivierungselemente aufweist, die wiederum galvanisch getrennt von der Elektronikeinheit ausgebildet sein können; und
- einem Trägergehäuse, welches vorzugsweise zur direkten Befestigung des Modulbauteils an einem vorgesehenen Ort, insbesondere an einer vorgesehenen Öffnung, am Fahrzeug ausgebildet ist.

Das Modulbauteil im Sinne der Erfindung ermöglicht auf diese Weise eine zuverlässige sowie sichere Funktionalität der Sensoreinheit(en) über eine verlängerte Lebensdauer des Modulbauteils. Das Modulbauteil im Sinne der Erfindung erfüllt weiterhin nicht nur verbesserte Sensorfunktionen, sondern auch verbesserte Beleuchtungsfunktionen, da insbesondere die mindestens zwei Aktivierungselemente derart verteilt an der Tastenkappe angeordnet werden können, dass verbesserte Beleuchtungsfunktionen bereitgestellt werden können. Zudem ist das erfindungsgemäße Modulbauteil derart zusammenhängend und kompakt ausgeführt, dass es als ein einziges Bauteil einfach gehandhabt und ohne großen Montageaufwand am Fahrzeug befestigt werden kann.

Eine Aktivierungshandlung im Sinne der Erfindung kann eine Berührung und/oder eine Kraftausübung vorsehen, bspw. von ung. 15 N, z. B. durch ein leichtes Drücken an der Tastenkappe. Die Aktivierungshandlung erfolgt insbesondere kontaktbehaftet. Zur Aufnahme der Aktivierungshandlung kann grundsätzlich die Tastenkappe als Ganzes bewegt und/oder eingedrückt und/oder verformt werden. Vorteilhafterweise kann zur Aufnahme der Aktivierungshandlung mindestens ein bestimmter Deformationsbereich an der Tastenkappe bewegt und/oder eingedrückt und/oder verformt werden. Die Aktivierungshandlung erfolgt dabei bevorzugt an einer Außenseite (Außenfläche) der Tastenkappe, die im normalen Betrieb des Fahrzeuges für einen Benutzer des Fahrzeuges zugänglich bzw. erreichbar und greifbar ist, bspw. beim Hintergreifen in eine Griffmulde. Die Tastenkappe und/oder der Deformationsbereich an der Tastenkappe können/kann dabei einen Betätigungsweg von ung. 0,01 mm bis 0,02 mm ausführen.

Die Tastenkappe kann ferner bewegbar am Trägergehäuse abgestützt sein. Dabei kann die Tastenkappe z. B. bei einer maximalen Krafteinwirkung von ung. 1000 N einen maximalen Verstellweg bis zu einem Hartanschlag am Trägergehäuse von ung. 0,4 mm ausführen.

Ferner kann die Tastenkappe verformbar ausgebildet sein, um die Aktivierungshandlung aufzunehmen.

Weiterhin kann die Tastenkappe mindestens einen Deformationsbereich aufweisen, welcher verformbar ausgeführt sein kann, um die Aktivierungshandlung aufzunehmen. Ferner können mehrere Deformationsbereiche für mehrere Aktivierungselemente vorgesehen sein.

Die Aktivierungshandlung kann dabei zum Betätigen des beweglichen Teils dienen. Unter einem Betätigen kann ein Entriegeln, Verriegeln, Öffnen und/oder Schließen des beweglichen Teils, insbesondere jedoch Entriegeln und/oder Öffnen, verstanden werden. Die Aktivierungshandlung kann somit insbesondere zum Entriegeln und, wenn ferner gewünscht, Öffnen, des beweglichen Teils dienen. Aber auch die Funktionen zum Verriegeln und/oder Schließen des beweglichen Teils können mithilfe des erfindungsgemäßen Modulbauteils bereitgestellt werden. Das bewegliche Teil kann bspw. als eine Tür, z. B. eine Front-, Seiten- und/oder Schiebetür, oder eine Klappe, z. B. eine Heckklappe, eine Tankklappe, eine Ladesteckerklappe, des Fahrzeuges ausgebildet sein. Das Fahrzeug kann bspw. als ein Kraftfahrzeug, ein Personenkraftfahrzeug und/oder ein Lastkraftfahrzeug ausgebildet sein.

Die Elektronikeinheit im Sinne der Erfindung kann vorzugsweise zuerst eine Präsenz und/oder eine Annäherung und/oder ein bestimmtes Bewegungsmuster eines Benutzers erkennen. Hierzu kann eine kapazitive Sensoreinheit an der Elektronikeinheit dienen. Danach kann die Elektronikeinheit im Sinne der Erfindung eine Identifikationsüberprüfung einleiten (bspw. mithilfe einer fahrzeugseitigen Kommunikationseinheit) und vorzugsweise direkt eine Beleuchtung der Tastenkappe einschalten. Durch die eingeschaltete Beleuchtung kann der Benutzer die Tastenkappe leicht auffinden, um eine Aktivierungshandlung an der Tastenkappe auszuführen. Nach dem Erfassen einer Aktivierungshandlung an der Tastenkappe kann ein Betätigen des beweglichen Teils, insbesondere ein Entriegeln und ggf. ein automatisches Öffnen, des beweglichen Teils eingeleitet werden. Hierzu kann die Elektronikeinheit im Sinne der Erfindung entsprechende Steuerbefehle an ein fahrzeugseitiges Steuergerät und/oder ein fahrzeugseitiges Schließsystem übermitteln.

Die Tastenkappe kann bspw. an einer Griffmulde eines türgrifflosen beweglichen Teils angeordnet sein. Die Tastenkappe kann bspw. verdeckt, aber durch Hintergreifen in die Griffmulde ertastbar, oder auch unmittelbar sichtbar, sei es an einem Griff, einer Griffmulde, einer Außenhaut oder an einem benachbarten Bauteil zum beweglichen Teil, angeordnet sein. Bei einer eingeschalteten Beleuchtung kann die Tastenkappe das Licht von der Leuchteinheit durchlassen. Hierzu kann die Tastenkappe durchlässig für das Licht von der Leuchteinheit ausgeführt sein. Die Tastenkappe kann außerdem das Licht von der mindestens einen Leuchtquelle auf eine besondere Weise streuen, formen und/oder ausrichten. Bei einer versteckt angeordneten Tastenkappe kann eine Lenkung des Lichtes in Richtung der Griffmulde, bspw. nach unten in Richtung Fahrboden, vorteilhaft sein. In diesem Falle kann man davon sprechen, dass die Tastenkappe eine indirekte Beleuchtung des Modulbauteils bereitstellt.

Ferner kann bei einem Modulbauteil vorgesehen sein, dass das Aktivierungselement ein elektrisch leitendes Material, bspw. Metall, vorzugsweise Aluminium oder Kupfer aufweist. Das Aktivierungselement kann bspw. in Form eines elektrisch leitenden Plättchens, z. B. mit einer Materialstärke von ung. 0,1 mm bis 0,5 mm, bspw. 0,2 mm, oder einer elektrisch leitenden Beschichtung, bspw. an einer Innenseite der Tastenkappe, ausgebildet sein. Das Aktivierungselement kann somit als bewegbares metallisches Element zum Induzieren eines messbaren elektrischen Stroms in der induktiven Sensoreinheit, bspw. mit zwei oder mehreren LDC-Sensoren, für eine Aktivierungshandlungserfassung dienen. Ein Verstellweg des Aktivierungselementes zur Aufnahme der Aktivierungshandlung kann bspw. zwischen 0,01 mm und 0,02 mm liegen.

Weiterhin kann bei einem Modulbauteil vorgesehen sein, dass die Aktivierungselemente scheibenförmig und/oder kreisförmig und/oder trichterförmig ausgeführt sind. Dadurch kann eine verbesserte Erkennbarkeit der Aktivierungshandlung ermöglicht werden. Durch solche Aktivierungselemente können sich die induzierten Wirbelströme in den Aktivierungselementen verstärkt ausbilden und eine deutlich messbare Veränderung des magnetischen Feldes in der induktiven Sensoreinheit bewirken. Durch solche Aktivierungselemente kann außerdem eine verbesserte Verteilung der Aktivierungselemente an der Tastenkappe ermöglicht werden, um eine symmetrische Anordnung der Aktivierungselemente zueinander und zu der Tastenkappe zu ermöglichen. Durch solche Aktivierungselemente kann zudem eine verbesserte Positionierung der Aktivierungselemente bezüglich der induktiven Sensoreinheit, bspw. mit zwei oder mehreren LDC-Sensoren, für eine Aktivierungshandlungserfassung ermöglicht werden. Durch solche Aktivierungselemente kann darüber hinaus eine verbesserte Positionierung der Aktivierungselemente bezüglich einer Leuchteinheit an der Elektronikeinheit bewirkt werden, sodass das Licht der Leuchteinheit sich möglichst ungehindert durch die Aktivierungselemente ausbreiten kann und auf eine verbesserte Weise die Tastenkappe durchleuchten kann.

Des Weiteren kann bei einem Modulbauteil vorgesehen sein, dass die Aktivierungselemente jeweils eine, insbesondere axial ausgebildete, Funktionsöffnung aufweisen. Durch die, insbesondere axial ausgebildeten, Funktionsöffnungen wird die Ausbildung der induzierten Wirbelströme in den Aktivierungselementen nahezu gar nicht gehindert. Zugleich kann durch die, insbesondere axial ausgebildeten, Funktionsöffnungen ein einfaches Positionieren und/oder Befestigen der Aktivierungselemente an der Tastenkappe bewirkt werden.

Im Rahmen der vorliegenden Offenbarung ist es denkbar, dass die Tastenkappe mindestens einen Deformationsbereich aufweisen kann, um eine Aktivierungshandlung, insbesondere eine Berührung und/oder Kraftausübung, eines Benutzers aufnehmen zu können. In diesem Falle können die Aktivierungselemente vorteilhafterweise an dem mindestens einen Deformationsbereich der Tastenkappe angeordnet sein, um mit dem Deformationsbereich bewegt zu werden. Grundsätzlich können auch mehrere, bspw. korrespondierende, Deformationsbereiche für mehrere Aktivierungselemente vorgesehen sein.

Zudem ist es denkbar, dass die Aktivierungselemente an der Tastenkappe befestigt sind, um mit der Tastenkappe als Ganzes und/oder mit mindestens einem Deformationsbereich der Tastenkappe bewegt zu werden und durch eine Bewegung der Aktivierungselemente relativ zu der induktiven Sensoreinheit eine messbare Induktivitätsänderung in der Sensoreinheit zu bewirken. Die Tastenkappe kann durch ein, insbesondere elastisch verformbares und/oder komprimierbares, Dichtungselement am Trägergehäuse befestigt werden. Mithilfe einer solchen Befestigung kann die Tastenkappe leicht eindrückbar am Trägergehäuse gelagert werden. Grundsätzlich ist aber auch möglich, dass mindestens ein Deformationsbereich der Tastenkappe zur Aufnahme der Betätigungshandlung ausreichen kann.

Vorteilhafterweise können die Aktivierungselemente derart an der Tastenkappe befestigt sein, dass die Aktivierungselemente beabstandet, vorzugsweise in einem bestimmten Abstand, zur induktiven Sensoreinheit angeordnet sein können. Durch den Abstand zwischen den Aktivierungselementen und der induktiven Sensoreinheit kann eine relative Bewegung der Aktivierungselemente zur induktiven Sensoreinheit ermöglicht werden, um vorzugsweise zum Erfassen einer Aktivierungshandlung eine Induktivitätsänderung, bspw. in mindestens einem LDC-Sensor, zu erzeugen. Durch einen bestimmten Abstand der Aktivierungselemente zur induktiven Sensoreinheit können die Aktivierungselemente entsprechend der Empfindlichkeit der induktiven Sensoreinheit angeordnet werden.

Außerdem kann es bei einem Modulbauteil von Vorteil sein, dass die Aktivierungselemente galvanisch getrennt von der Elektronikeinheit angeordnet sind. Dadurch kann der Zusammenbau des Modulbauteils und das elektrische Verschalten von Sensoreinheiten erheblich erleichtert werden. Außerdem kann dadurch die Funktionalität der Elektronikeinheit und der Sensoreinheiten über eine verlängerte Lebensdauer des Modulbauteils sichergestellt werden.

Ferner kann bei einem Modulbauteil vorgesehen sein, dass die Aktivierungselemente zwischen der Tastenkappe und der Elektronikeinheit positioniert sind. Auf diese Weise können die Aktivierungselemente relativ zur Elektronikeinheit bewegt werden.

Weiterhin kann bei einem Modulbauteil vorgesehen sein, dass die Aktivierungselemente an einer Innenseite der Tastenkappe form- und/oder kraftschlüssig befestigt sind. Auf diese Weise können die Aktivierungselemente einfach und ohne großen Aufwand an der Tastenkappe befestigt werden. Auch kann somit eine lösbare Befestigung der Aktivierungselemente an der Tastenkappe ermöglicht werden.

Des Weiteren kann bei einem Modulbauteil vorgesehen sein, dass an einer Innenseite der Tastenkappe Positionierungsstifte zum Positionieren und/oder Befestigen der Aktivierungselemente vorgesehen, insbesondere einstückig und/oder materialeinheitlich mit der Tastenkappe ausgeformt, sind. Auf diese Weise können die Positionierung und die Befestigung der Aktivierungselemente an der Tastenkappe intuitiv und einfach erfolgen.

Vorteilhafterweise können die Positionierungsstifte dazu ausgeführt sein, um die Aktivierungselemente durch Ultraschallschweißen oder Heißverstemmen an der Tastenkappe zu befestigen. Ultraschallschweißen kann dabei die bevorzugte Methode sein, um die Aktivierungselemente möglichst schonend zu befestigen, vorzugsweise ohne Fädenziehen. Hierzu können die Aktivierungselemente mit den Funktionsöffnungen an den Positionierungsstiften angeordnet werden, sodass die Spitzen der Aktivierungselemente durch die Aktivierungselemente ragen. Die Spitzen der Aktivierungselemente können mithilfe von Ultraschall aufgeweicht werden und wieder erstarren, um die Aktivierungselemente verliersicher an der Tastenkappe zu halten.

Zudem kann bei einem Modulbauteil vorgesehen sein, dass an einer Innenseite der Tastenkappe, insbesondere kreisförmige, Konturelemente und/oder, insbesondere stegförmige, Stützelemente zum Abstützen der Aktivierungselemente, vorzugsweise in einem bestimmten Abstand, zu der Tastenkappe vorgesehen, insbesondere ausgeformt, sind. Auf diese Weise können die Aktivierungselemente nicht nur stabil, sondern auch in einem bestimmten Abstand zu der Tastenkappe befestigt werden.

Denkbar ist außerdem, dass die, insbesondere stegförmigen, Stützelemente als Stützrippen für die, insbesondere kreisförmigen, Konturelemente ausgeführt sein können. Auf diese Weise kann eine besonders stabile und zuverlässige Auflage für die Aktivierungselemente an der Innenseite der Tastenkappe geschaffen werden.

Ferner kann bei einem Modulbauteil vorgesehen sein, dass die Tastenkappe derart, insbesondere von einer Außenseite des Trägergehäuses, am Trägergehäuse abgestützt ist, und dass die Elektronikeinheit derart, insbesondere von einer Innenseite des Trägergehäuses, am Trägergehäuse befestigt ist, dass zwischen der Tastenkappe und der Elektronikeinheit eine Luftkammer ausgebildet ist. Vorteilhafterweise kann die Luftkammer durch die Anbringung einerseits der Tastenkappe und andererseits der Elektronikeinheit am Trägergehäuse abgeschlossen und insbesondere abgedichtet werden (zum Abdichten kann ein die Tastenkappe umfangsseitig umlaufendes, insbesondere balgförmiges, Dichtungselement dienen). In der Luftkammer kann eine geschützte Anbringung der Sensoreinheiten und der Aktivierungselemente ermöglicht werden.

Weiterhin kann bei einem Modulbauteil vorgesehen sein, dass die Elektronikeinheit mindestens eine (oder mehrere) Leuchteinheit(en) zum Durchleuchten der Tastenkappe aufweist. Mithilfe von Leuchteinheiten kann die Tastenkappe durchleuchtet werden, um die Auffindbarkeit des Modulbauteils zu erleichtern. Dabei kann die mindestens eine Leuchteinheit dazu ausgeführt sein, ein Licht, bspw. sichtbares Licht, in die Luftkammer auszustrahlen, welches die Tastenkappe durchleuchten kann. Zudem kann die mindestens eine Leuchteinheit mindestens ein, vorzugsweise zwei oder mehrere Leuchtelemente, bspw. in Form von LED-Elementen, aufweisen. Auf diese Weise kann das Licht besser gestreut und/oder verteilt werden, um ein gleichmäßiges Hinterleuchten der Tastenkappe zu ermöglichen. Vorteilhafterweise können die Aktivierungselemente mit einem seitlichen Abstand zu den Leuchtelementen angeordnet sein. Auf diese Weise kann sichergestellt werden, dass die Aktivierungselemente die Leuchtelemente möglichst nicht abschirmen und dass sich das Licht der Leuchtelemente möglichst ungehindert zum Durchleuchten der Tastenkappe ausbreiten kann. Außerdem kann es von Vorteil sein, dass an der Tastenkappe, insbesondere an einer Innenseite der Tastenkappe, mindestens eine Streustruktur vorgesehen, insbesondere ausgeformt ist, um ein Licht von der mindestens einen Leuchteinheit zu streuen, zu lenken und/oder auszurichten. Somit kann das Licht auf eine verbesserte Weise verteilt und in eine Richtung zu einer Griffmulde am beweglichen Teil des Fahrzeuges gelenkt werden.

Des Weiteren kann bei einem Modulbauteil vorgesehen sein, dass die Tastenkappe, insbesondere zumindest in einer unbetätigten Stellung, derart am Trägergehäuse abgestützt ist, dass sich eine Außenseite der Tastenkappe im Wesentlichen flächenbündig zu oder hervorstehend (bspw. im Bereich von wenigen Mikrometern bis zu wenigen Millimetern) von einer Außenseite des Trägergehäuses erstreckt. Durch eine flächenbündige Anordnung kann eine unauffällige Optik der Tastenkappe ermöglicht werden. Durch eine hervorstehende Anordnung kann das Ertasten und somit das Auffinden der Tastenkappe erleichtert werden.

Zudem ist es denkbar, dass die Tastenkappe, insbesondere zumindest in einer unbetätigten Stellung, derart an dem Trägergehäuse abgestützt sein kann, dass zwischen einer Außenseite der Tastenkappe und einer Außenseite des Trägergehäuses umfangsseitig der Tastenkappe ein umlaufender Spalt ausgebildet ist. Somit kann ein Ertasten und somit Auffinden der Tastenkappe erleichtert werden.

Vorteilhafterweise, kann der Bereich des umlaufenden Spalts durch ein, insbesondere balgförmiges, Dichtungselement ausgefüllt sein, um eine Öffnung im Trägergehäuse abzudichten und insbesondere die Sensoreinheiten und die Aktivierungselemente vor Witterungseinflüssen, insbesondere vor Feuchtigkeit, zu schützen. Mit anderen Worten kann dadurch eine Luftkammer zwischen der Tastenkappe und der Elektronikeinheit abgedichtet werden.

Außerdem kann bei einem Modulbauteil vorgesehen sein, dass die induktive Sensoreinheit mindestens zwei oder mehrere, insbesondere symmetrisch an der Elektronikeinheit verteilte, induktive Sensorelemente, bspw. in Form von LDC-Sensoren, für eine Aktivierungshandlungserfassung an der Tasteneinheit aufweist. Mithilfe von induktiven Sensoren können kleinste Bewegungen im Bereich von wenigen Mikrometern bis zu wenigen Millimetern sensitiv und/oder hochaufgelöst erfasst werden. Somit kann ermöglicht werden, dass bereits durch eine leichte Berührung der Tastenkappe durch eine Hand oder einen Finger des Benutzers eine Aktivierungshandlung erfasst werden kann.

Darüber hinaus kann bei einem Modulbauteil vorgesehen sein, dass die Elektronikeinheit eine kapazitive Sensoreinheit für eine Präsenzerfassung an der Tasteneinheit aufweist, die wiederum (mindestens) ein (oder mehrere) kapazitive(s) Sensorelement(e) und/oder eine kapazitive Auswerteinheit umfasst. Auf diese Weise kann eine Erfassung einer Annäherung eines Benutzers an das Modulbauteil ermöglicht werden.

Ferner kann bei einem Modulbauteil vorgesehen sein, dass die Elektronikeinheit eine Steuereinheit aufweist. Mithilfe der Steuereinheit können vorteilhafte Funktionen eines Zugangssystems zum Fahrzeug, bspw. in Form eines Keyless-Go- und/oder eines Keyless-Entry-Systems, bereitgestellt werden. Die Steuereinheit kann vorteilhafterweise mit einem Steuergerät oder direkt mit einem Schließsystem des Fahrzeuges in steuerungstechnischer und/oder kommunikationstechnischer Wirkverbindung stehen. Zum Zweck einer Identifikationsüberprüfung kann die Steuereinheit mit einer fahrzeugseitigen Kommunikationseinheit, bspw. in Form einer Funkeinheit oder einer NFC-Einheit, in steuerungstechnischer und/oder kommunikationstechnischer Wirkverbindung stehen, um eine Berechtigung des Benutzers zu verifizieren.

Weiterhin kann bei einem Modulbauteil vorteilhaft sein, dass die Steuereinheit mit mindestens einer fahrzeugseitigen Kommunikationseinheit, bspw. in Form einer Funkeinheit und/oder einer NFC-Einheit, in eine Kommunikationsverbindung gebracht werden kann, die wiederum mit einem mobilen ID-Geber in eine Signalverbindung gebracht werden kann, um eine Identifikationsüberprüfung des Benutzers durchzuführen. Auf diese Weise kann die Steuereinheit einen Teil eines Zugangssystems zum Fahrzeug, bspw. in Form eines Keyless-Go- und/oder eines Keyless-Entry-Systems, bilden.

Des Weiteren kann bei einem Modulbauteil vorteilhaft sein, dass die Steuereinheit mit einem fahrzeugseitigen Steuergerät und/oder einem fahrzeugseitigen Schließsystem in eine Kommunikationsverbindung gebracht werden kann, um ein Betätigen des beweglichen Teils des Fahrzeuges einzuleiten. Somit können mithilfe der Steuereinheit die Funktionen der Betätigung des beweglichen Teils eingeleitet werden.

Zudem kann bei einem Modulbauteil vorgesehen sein, dass die Steuereinheit dazu ausgeführt ist, eine Präsenzerfassung des Benutzers durch eine kapazitive Sensoreinheit zu erfassen. Unter einer Präsenzerfassung kann eine Erfassung einer Präsenz, einer Annäherung, einer bestimmten Bewegung in eine besondere Richtung oder sogar eines bestimmten Bewegungsmusters, bspw. aus einer entfernten Zone in eine nähere Zone, verstanden werden. Mithilfe der Sensoreinheit kann somit eine, vorteilhafterweise, energiesparende Überwachung des Außenraumes des Fahrzeuges ermöglicht werden, bspw. in einer Distanz von mehreren Metern oder sogar mehreren Hundert Metern. Die Präsenzerfassung kann dazu genutzt werden, einen Benutzer in der Nähe des Fahrzeuges zu erkennen und erst nach einer Präsenzerfassung sämtliche anderen Sensoren und/oder Einheiten einzuschalten, die ggf. mehr Energie benötigen.

Vorteilhafterweise kann die Steuereinheit dazu ausgeführt sein, vorzugsweise nach einer positiven Präsenzerfassung des Benutzers, eine fahrzeugseitige Kommunikationseinheit zu verlassen, um eine Identifikationsüberprüfung zwischen der fahrzeugseitigen Kommunikationseinheit und einem ID-Geber durchzuführen. Auf diese Weise kann mithilfe der Steuereinheit eine energiesparsame Funktionsweise eines Zugangssystems zum Fahrzeug ermöglicht werden.

Im Rahmen der Erfindung ist es grundsätzlich denkbar, dass die Steuereinheit dazu ausgeführt sein kann, vorzugsweise nach einer positiven Präsenzerfassung und/oder einer positiven Identifikationsüberprüfung des Benutzers, eine Beleuchtung der Tastenkappe einzuschalten, um ein Auffinden der Tastenkappe zu erleichtern.

Vorzugsweise kann die Steuereinheit dazu ausgeführt sein, nach einer positiven Identifikationsüberprüfung, eine Aktivierungshandlung des Benutzers an der Tastenkappe durch mindestens eine induktive Sensoreinheit zu erfassen. Nach einer positiven Aktivierungshandlungserfassung des Benutzers an der Tastenkappe kann die Steuereinheit ein fahrzeugseitiges Steuergerät und/oder ein fahrzeugseitiges Schließsystem veranlassen, das bewegliche Teil des Fahrzeuges zu betätigen.

Am Trägergehäuse kann eine Öffnung für die Tasteneinheit vorgesehen sein, durch welche vorteilhafterweise eine induktive Erfassung einer Aktivierungshandlung erfolgen kann. Für einen vereinfachten Zusammenbau des Modulbauteils, kann das Trägergehäuse einen wannenförmigen Sitz für die Tasteneinheit aufweisen. Dabei kann die Öffnung an einem Boden des wannenförmigen Sitzes ausgebildet sein. Die Tasteneinheit, mit der Tastenkappe, dem Aktivierungselement und dem Dichtungselement, kann einfach und bequem in einem solchen Sitz positioniert werden.

Vorteilhafterweise kann die Tastenkappe, vorzugsweise mithilfe von einem Dichtungselement, von einer Außenseite des Trägergehäuses am Trägergehäuse, insbesondere an einer Öffnung im Trägergehäuse, befestigt werden.

Zusätzlich ist es optional möglich, dass die Tastenkappe mithilfe vom Dichtungselement bewegbar am Trägergehäuse, insbesondere an einer Öffnung im Trägergehäuse, abgestützt sein kann, um durch elastische Verformung des Dichtungselementes eine Aktivierungshandlung eines Benutzers durch die Öffnung im Trägergehäuse aufnehmen zu können.

Vorteilhafterweise kann vorgesehen sein, dass mindestens ein oder mehrere verformbare Bereiche an der Tastenkappe bereitgestellt werden können, um eine Aktivierungshandlung eines Benutzers aufnehmen zu können.

Darüber hinaus ist es denkbar, dass das Trägergehäuse, insbesondere an einer Außenseite, vorzugsweise an einem wannenförmigen Sitz, Positionierhilfe und/oder Zentrierhilfe für die Tastenkappe aufweisen kann. Auf diese Weise kann das Positionieren der Tasteneinheit beim Zusammenbau des Modulbauteils noch weiter erleichtert werden.

Ferner kann bei einem Modulbauteil vorgesehen sein, dass das Trägergehäuse, insbesondere an einer Innenseite, eine Rahmenstruktur für die Elektronikeinheit aufweist, wobei insbesondere die Rahmenstruktur die Öffnung und insbesondere die Tasteneinheit umfangsseitig umschließt und insbesondere als eine Vergusswanne zum Vergießen der Elektronikeinheit dient. Mithilfe der Rahmenstruktur kann die Elektronikeinheit einfach und bequem am Trägergehäuse befestigt werden und vorzugsweise von innen bezüglich der Außenfläche der Tastenkappe vergossen und somit befestigt und abgedichtet werden. Für eine bessere Positionierung der Elektronikeinheit kann die Rahmenstruktur die Öffnung und insbesondere die Tasteneinheit umranden.

Vorteilhafterweise kann die Elektronikeinheit von einer Innenseite des Trägergehäuses am Trägergehäuse, insbesondere an einer Öffnung im Trägergehäuse, vorzugsweise hinter der Tastenkappe, angeordnet und/oder mit einer Vergussmasse vergossen sein, um die Elektronikeinheit zu befestigen und/oder abzudichten.

Darüber hinaus ist es denkbar, dass das Trägergehäuse, insbesondere an einer Innenseite, vorzugsweise an einer Rahmenstruktur, Positionierhilfe und/oder Zentrierhilfe für die Elektronikeinheit aufweisen kann. Auf diese Weise kann das Positionieren der Elektronikeinheit beim Zusammenbau des Modulbauteils erleichtert werden.

Weiterhin kann bei einem Modulbauteil vorgesehen sein, dass das Trägergehäuse ein Spritzgussbauteil ist, und/oder dass das Trägergehäuse ein formstabiles Material, insbesondere Kunststoff, vorzugsweise Hartplastik, aufweist. Auf diese Weise kann ein einfaches, kostengünstiges und leichtes Trägergehäuse zur Befestigung des Modulbauteils am Fahrzeug bereitgestellt werden.

Des Weiteren kann bei einem Modulbauteil vorgesehen sein, dass die Tastenkappe ein formstabiles und/oder durchsichtiges (gemeint ist für das Licht im sichtbaren Spektrum oder zumindest für das Licht im Lichtspektrum der mindestens einen Leuchteinheit durchsichtiges) Material, insbesondere Kunststoff, vorzugsweise Polymer, bevorzugt Polyamid, aufweisen kann. Auf diese Weise kann die Tastenkappe, dass Licht der mindestens einen Leuchteinheit durchlassen, um die Tastenkappe zu hinterleuchten und, wenn gewünscht, eine Griffmulde oder einen anderen Bereich am beweglichen Teil zu beleuchten.

Zudem kann bei einem Modulbauteil vorgesehen sein, dass an der Tastenkappe ein, insbesondere balgförmiges, Dichtungselement angeordnet ist, um eine Öffnung im Trägergehäuse abzudichten und insbesondere die Sensoreinheiten und die Aktivierungselemente vor Witterungseinflüssen zu schützen. Das Dichtungselement kann dabei die Tastenkappe umranden und abdichtend an der Öffnung im Trägergehäuse zur Auflage kommen.

Vorteilhafterweise kann das Dichtungselement dazu ausgeführt sein, die Tastenkappe am Trägergehäuse, bevorzugt an einer Öffnung im Trägergehäuse, insbesondere durch ein Laserschweißverfahren, zu befestigen. Hierzu kann das Dichtungselement ein elastisches Material, insbesondere Kunststoff, vorzugsweise Elastomer, bevorzugt thermoplastischen Elastomer, aufweisen. Auf diese Weise kann das Dichtungselement mehrere Funktionen erfüllen, wie z. B.: Abdichten und Befestigen Die Tastenkappe kann somit einfach und kostengünstig hergestellt werden.

Die Aufgabe der Erfindung wird ferner gelöst durch ein Verfahren zum Herstellen eines Modulbauteils, welches wie oben beschrieben ausgeführt sein kann, für ein bewegliches Teil eines Fahrzeuges, aufweisend:
- Bereitstellen eines Trägergehäuses zum Befestigen des Modulbauteils am beweglichen Teil des Fahrzeuges,
- Bereitstellen einer Tasteneinheit zum Betätigen des beweglichen Teils des Fahrzeuges mit einer Tastenkappe und zwei Aktivierungselementen,
- Abstützen der Tastenkappe, insbesondere von außen, am Trägergehäuse zum Aufnehmen einer Aktivierungshandlung, insbesondere einer Berührung und/oder einer Kraftausübung, eines Benutzers,
- Befestigen der Aktivierungselemente, insbesondere von innen, an der Tastenkappe,
- Bereitstellen einer Elektronikeinheit zum Bereitstellen von Sensorfunktionen beim Betätigen des beweglichen Teils des Fahrzeuges mit einer induktiven Sensoreinheit für eine Aktivierungshandlungserfassung an der Tasteneinheit,
- Befestigen einer Elektronikeinheit, insbesondere von innen, am Trägergehäuse.

Mithilfe des erfindungsgemäßen Verfahrens können die gleichen Vorteile erreicht werden, die oben im Zusammenhang mit dem erfindungsgemäßen Modulbauteil beschrieben wurden. Auf diese Vorteile wird vorliegend vollumfänglich Bezug genommen. Die Schritte des erfindungsgemäßen Verfahrens können in der vorgegebenen oder in einer abgeänderten Reihenfolge durchgeführt werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Figur 1: eine perspektivische Sicht auf ein bewegliches Teil eines Fahrzeuges, bspw. in Form einer Tür, welches bzw. welche eine Griffmulde aufweist, in welcher ein Modulbauteil im Rahmen der Erfindung befestigt werden kann,
- Figur 2: eine perspektivische Sicht auf ein Modulbauteil im Rahmen der Erfindung, welches an die Form einer Griffmulde angepasst ist und/oder zumindest zum Teil die Griffmulde ausbilden kann,
- Figur 3: ein Modulbauteil im Rahmen der Erfindung in der Sicht auf eine Außenseite einer Tastenkappe des Modulbauteils, welche lichtdurchlässig, bspw. für ein sichtbares Licht, ausgeführt ist,
- Figur 4: eine Schnittdarstellung durch ein Modulbauteil im Rahmen der Erfindung,
- Figur 5: ein Modulbauteil im Rahmen der Erfindung in der Sicht auf eine Innenseite einer Tastenkappe des Modulbauteils, und
- Figur 6: eine weitere Darstellung eines Modulbauteils im Rahmen der Erfindung in der Sicht auf eine Innenseite einer Tastenkappe des Modulbauteils.

In den nachfolgenden Figuren werden für die gleichen technischen Merkmale auch von unterschiedlichen Ausführungsbeispielen die identischen Bezugszeichen verwendet. In der Regel werden die Bezugszeichen von den gleichen Ausführungsbeispielen nur einmal beschrieben.

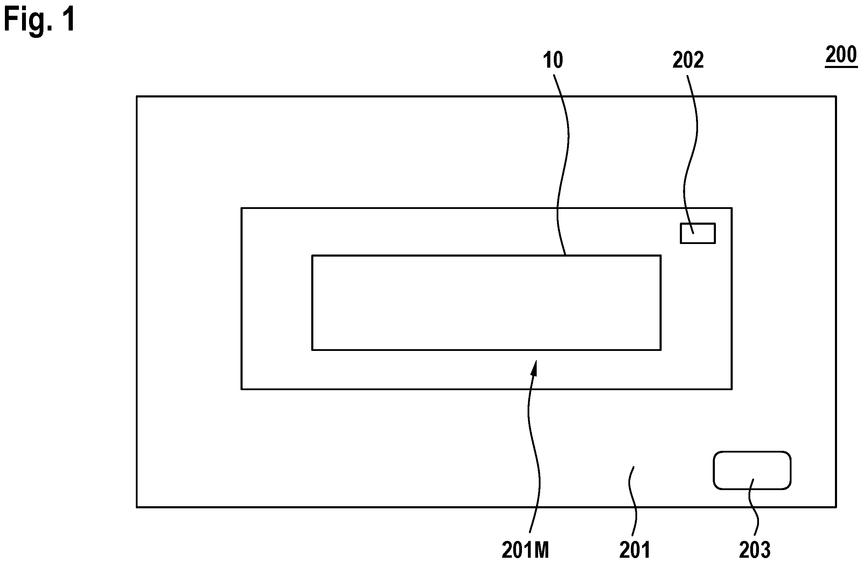

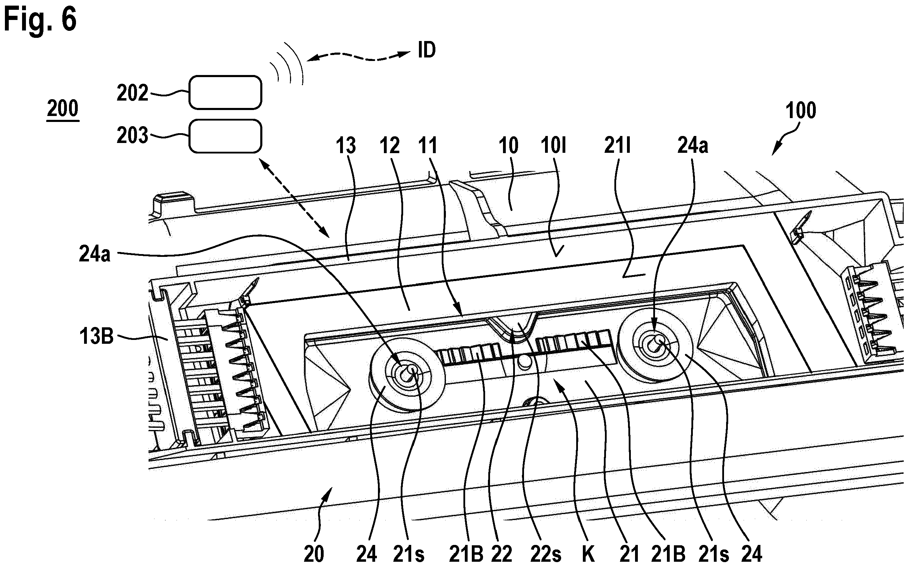

Die Figuren 1 bis 6 dienen dazu, ein Modulbauteil 100 für ein bewegliches Teil 201 eines Fahrzeuges 200 sowie ein Herstellungsverfahren zum Herstellen eines solchen Modulbauteils 100 zu beschreiben. Das Modulbauteil 100 ist zum Betätigen, d. h. Entriegeln, Öffnen, Verriegeln und/oder Schließen, des beweglichen Bauteils 201 ausgeführt. Ein bewegliches Teil 201 kann z. B. eine Tür oder eine Klappe des Fahrzeuges 200 sein. Das Fahrzeug 200 im Ganzen ist in den Figuren lediglich aus Einfachheitsgründen nicht dargestellt.

Das Modulbauteil 100 kann vorzugsweise als einzeln handhabbares, zusammenhängendes Modulbauteil ausgeführt sein. Das Modulbauteil 100 kann nach dem Zusammenbau seiner Elemente 10, 20, 30 im Ganzen an einem vorgesehenen Ort am Fahrzeug 200 montiert werden. Das Modulbauteil 100 kann mithilfe des Trägergehäuses 10 an einem feststehenden Griff, einer Griffmulde 201M und/oder einer Außenhaut des beweglichen Teils und/oder an einem zum beweglichen Teil 201 angrenzendem Bauteil des Fahrzeuges 200 befestigt werden.

Das Modulbauteil 100 umfasst:
- ein Trägergehäuse 10 zum Befestigen des Modulbauteils 100 am beweglichen Teil 201 des Fahrzeuges 200,
- eine Tasteneinheit 20 zum Betätigen des beweglichen Teils 201 des Fahrzeuges 200,
   wobei die Tasteneinheit 20 eine Tastenkappe 21 aufweist, die dazu ausgeführt ist, eine Aktivierungshandlung, wie z. B. eine Berührung und/oder Kraftausübung, eines Benutzers aufnehmen zu können,
   und wobei an der Tastenkappe 21 mindestens zwei oder mehrere, insbesondere symmetrisch an der Tastenkappe verteilte, Aktivierungselemente 24 angeordnet sind, um die Aktivierungshandlung des Benutzers erfassen zu können,
- und eine Elektronikeinheit 30 zum Bereitstellen von Sensorfunktionen beim Betätigen des beweglichen Teils 201 des Fahrzeuges 200,
   wobei die Elektronikeinheit 30 am Trägergehäuse 10 befestigt ist,
   und wobei die Elektronikeinheit 30 eine induktive Sensoreinheit 31 für eine Aktivierungshandlungserfassung an der Tasteneinheit 20 aufweist.

Die Erfindung erkennt die Problematik der eingeschränkten Funktionsweise von Sensoreinheiten mit betätigbaren Teilen, wie z. B. bewegbaren und/oder zumindest zum Teil verformbaren Tastenkappen, bei denen die einzelnen Sensoreinheiten nicht immer und/oder nicht immer zuverlässig für eine vorgesehene Betriebsdauer elektrisch kontaktiert werden können. Die Erfindung stellt ein kombiniertes Modulbauteil 100 mit folgenden Elementen 10, 20, 30 bereit: einer modular ausgestalteten Elektronikeinheit 30, die eine funktionstechnisch sowie verschaltungstechnisch integrierte induktive Sensoreinheit 31, ggf. eine funktionstechnisch sowie verschaltungstechnisch integrierte kapazitive Sensoreinheit 32 und/oder eine Beleuchtungseinheit 33, aufweist; einer bewegbaren und/oder zumindest bereichsweise verformbaren Tasteneinheit 20, die mindestens zwei Aktivierungselemente 24 aufweist, die wiederum galvanisch völlig getrennt von der Elektronikeinheit 30 ausgebildet sein können; und einem Trägergehäuse 10, welches zur direkten Befestigung an einer Öffnung am beweglichen Teil 201 und/oder an einem zum beweglichen Teil 201 angrenzendem Bauteil des Fahrzeuges 200 ausgeführt ist. Das Modulbauteil 100 kann auf diese Weise verbesserte Sensorfunktionen sowie eine zuverlässige sowie sichere Funktionalität der Sensoreinheit(en) 31, 32 über eine verlängerte Lebensdauer des Modulbauteils 100 ermöglichen. Das Modulbauteil 100 ermöglicht außerdem verbesserte Beleuchtungsfunktionen, da insbesondere die zwei Aktivierungselemente 24 derart verteilt an der Tastenkappe 21 angeordnet werden können, das die Beleuchtungsfunktionen nicht gestört werden. Zudem ist das erfindungsgemäße Modulbauteil 100 derart zusammenhängend und kompakt ausgeführt, dass es als ein einziges Bauteil bequem gehandhabt und einfach am Fahrzeug befestigt werden kann.

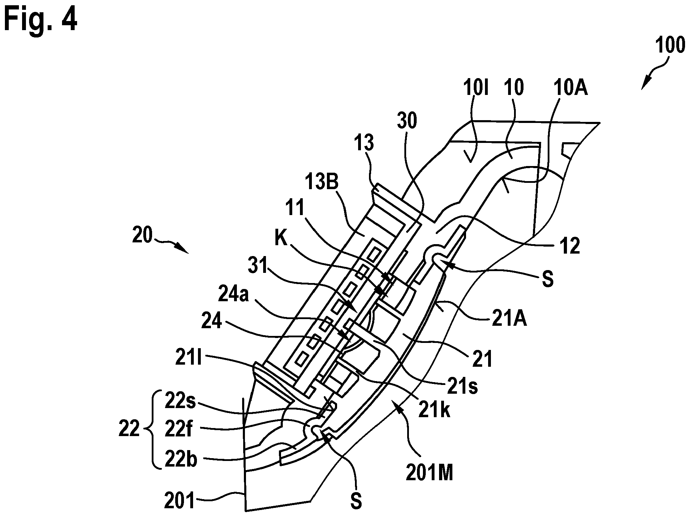

Eine Aktivierungshandlung im Sinne der Erfindung kann eine Berührung und/oder eine Kraftausübung umfassen, bspw. von ung. 15 N, z. B. durch ein leichtes Drücken, an der Tastenkappe 21. Die Aktivierungshandlung erfolgt somit kontaktbehaftet an einer Außenseite 21A (bzw. einer Außenfläche) der Tastenkappe 21. Wie es die Figur 4 verdeutlicht, ist die Tastenkappe 21 nach der Montage des Modulbauteils 100 am Fahrzeug 200 für einen Benutzer des Fahrzeuges 200 zugänglich bzw. erreichbar und/oder greifbar am beweglichen Teil 201 anordenbar. Der Benutzer kann die Tastenkappe 21 bspw. durch ein Hineingreifen in eine Griffmulde 201M anfassen. Bei einem Aufnehmen einer Aktivierungshandlung kann die Tastenkappe 21 einen Betätigungsweg von ung. 0,05 mm ausführen. Die Tastenkappe 21 kann verformbar ausgeführt sein und/oder mindestens einen Deformationsbereich aufweisen, sodass eine Betätigungsbewegung von ung. 0,01 mm bis 0,02 mm zur Aufnahme der Aktivierungshandlung ausgeführt werden kann. Im Falle einer beweglichen Lagerung der Tastenkappe 21 am Trägergehäuse 10 kann die Tastenkappe 21 bspw. bei einer maximalen Krafteinwirkung von ung. 1000 N einen maximalen Verstellweg bis zu einem Hartanschlag am Trägergehäuse 10 von ung. 0,4 mm ausführen.

Das jeweilige Aktivierungselement 24 kann ein elektrisch leitendes Material, bspw. Metall, vorzugsweise Aluminium oder Kupfer aufweisen. Das jeweilige Aktivierungselement 24 kann bspw. in Form eines elektrisch leitenden Plättchens, z. B. mit einer Materialstärke von ung. 0,1 mm bis 0,5 mm, bspw. 0,2 mm, oder einer elektrisch leitenden Beschichtung, bspw. zumindest im Bereich eines Deformationsbereiches, an einer Innenseite 211 der Tastenkappe 21, ausgebildet sein. Das Aktivierungselement 24 kann somit als bewegbares metallisches Element zum Induzieren eines messbaren elektrischen Stroms in der induktiven Sensoreinheit 31, bspw. mit zwei oder mehreren LDC-Sensoren, für eine Aktivierungshandlungserfassung dienen. Der Verstellweg des jeweiligen Aktivierungselementes 24 zur Aufnahme der Aktivierungshandlung kann zwischen ung. 0,01 mm bis 0,02 mm liegen.

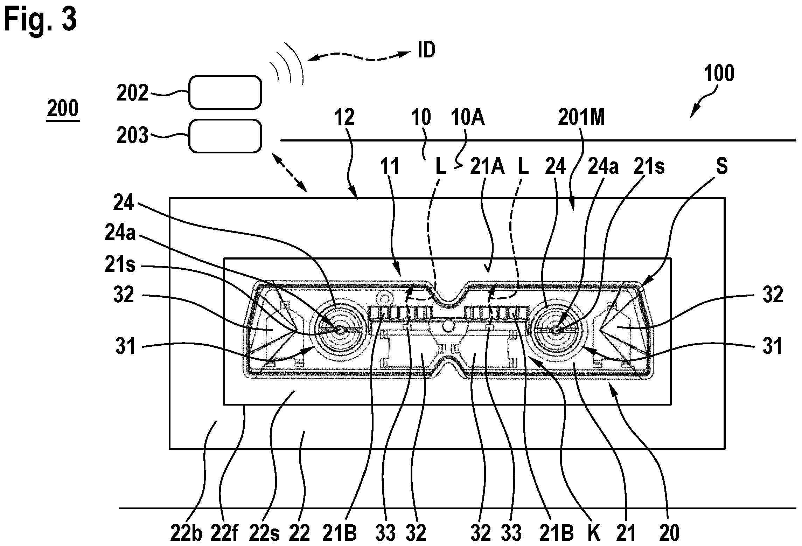

Die Figur 3 zeigt eine Ansicht auf die Tastenkappe 21, die vorteilhafterweise durchsichtig ist, zumindest für ein sichtbares Licht, insbesondere für das Licht der Leuchteinheit 33. Da die Tastenkappe 21 durchsichtig ist, können in der Ansicht der Figur 3 die darunter angeordneten Elemente gesehen werden. Die Form der durchsichtigen Tastenkappe 21 ist in der Figur 3 durch seitlich zulaufende Konturlinien angedeutet.

Wie es die Figuren 3, 4 und 6 verdeutlichen, können die Aktivierungselemente 24 vorteilhafterweise scheibenförmig und/oder kreisförmig und/oder trichterförmig ausgeführt sein. Durch eine solche Ausgestaltung der Aktivierungselemente 24 kann eine verbesserte Erkennbarkeit der Aktivierungshandlung ermöglicht werden. Durch solche Aktivierungselemente 24 können sich die induzierten Wirbelströme in den Aktivierungselementen 24 ungehindert ausbilden und eine messbare Veränderung des magnetischen Feldes in der induktiven Sensoreinheit 31 bewirken. Durch solche Aktivierungselemente 24 kann außerdem eine verbesserte Verteilung der Aktivierungselemente 24 an der Tastenkappe 21 ermöglicht werden, insbesondere im Hinblick auf eine verbesserte Aktivierungshandlungserfassung, auf eine verbesserte Positionierung der Aktivierungselemente 24 bezüglich der induktiven Sensoreinheit 31 und auf eine verbesserte Positionierung der Aktivierungselemente 24 bezüglich einer Leuchteinheit 33 an der Elektronikeinheit 30.

Wie es die Figuren 3, 4 und 6 verdeutlichen, können die Aktivierungselemente 24 jeweils eine, insbesondere axial ausgebildete, Funktionsöffnung 24a aufweisen. Durch die, insbesondere axial ausgebildeten, Funktionsöffnungen 24a wird die Ausbildung der induzierten Wirbelströme in den Aktivierungselementen 24 im Wesentlichen nicht gestört. Zugleich können die, insbesondere axial ausgebildeten, Funktionsöffnungen 24a ein einfaches Positionieren und/oder Befestigen der Aktivierungselemente 24 an der Tastenkappe 21, insbesondere an speziell dafür vorgesehenen Positionierungsstiften 21s, bewirken.

Nach dem Befestigen der Aktivierungselemente 24 an der Tastenkappe 21 können die Aktivierungselemente 24 mit der Tastenkappe 21 und/oder mit mindestens einem Deformationsbereich der Tastenkappe 21 bewegt werden, um eine Aktivierungshandlung aufnehmen zu können. Durch eine Bewegung der Aktivierungselemente 24 relativ zu der induktiven Sensoreinheit 31 kann eine messbare Induktivitätsänderung in der induktiven Sensoreinheit 31 erzeugt werden.

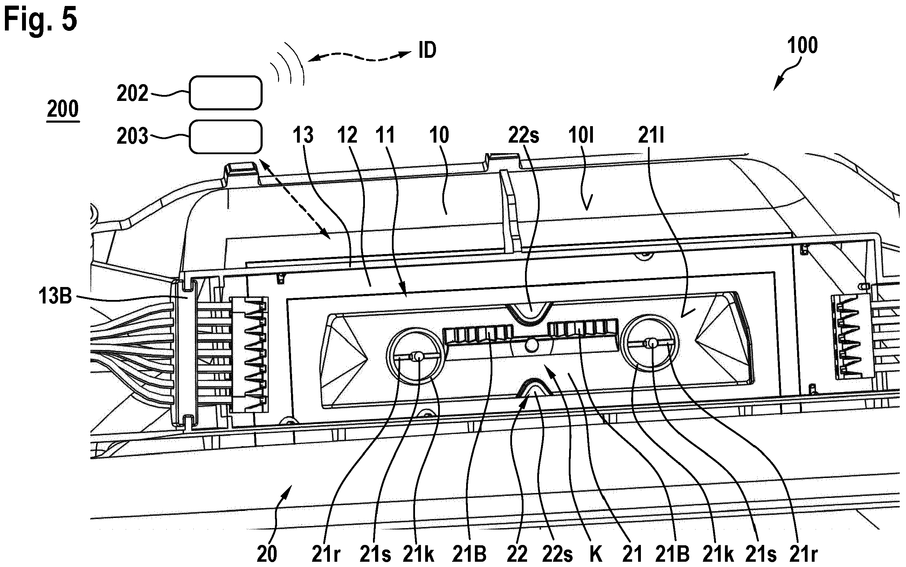

Wie es die Figuren 4 und 5 andeuten, können die Aktivierungselemente 24 derart an der Tastenkappe 21 befestigt sein, dass die Aktivierungselemente 24 beabstandet, vorzugsweise in einem bestimmten Abstand, zur induktiven Sensoreinheit 31 angeordnet werden können. Auf diese Weise kann die Empfindlichkeit der induktiven Sensoreinheit 31 auf eine vorteilhafte Weise berücksichtigt werden.

Wie oben bereits erwähnt, kann es außerdem von Vorteil sein, dass die Aktivierungselemente 24 galvanisch getrennt von der Elektronikeinheit 30 angeordnet sind. Dadurch kann der Zusammenbau des Modulbauteils 100 und das Verschalten von Sensoreinheiten 31, 32, insbesondere einer kapazitiven Sensoreinheit 32, erheblich erleichtert werden. Auf diese Weise kann die Funktionalität der Elektronikeinheit 30 und der Sensoreinheiten 31, 32, insbesondere der kapazitiven Sensoreinheit 32, über eine verlängerte Lebensdauer des Modulbauteils 100 sichergestellt werden.

Wie es die Figur 4 zudem verdeutlicht, können die Aktivierungselemente 24 zwischen der Tastenkappe 21 und der induktiven Sensoreinheit 31 positioniert sein.

Einfachheitshalber können die Aktivierungselemente 24 form- und/oder kraftschlüssig an einer Innenseite 211 der Tastenkappe 21 befestigt sein. Wie es die Figuren 3 bis 6 verdeutlichen, können an einer Innenseite 211 der Tastenkappe 21 Positionierungsstifte 21s zum Positionieren und/oder Befestigen der Aktivierungselemente 24 vorgesehen sein. Die Positionierungsstifte 21s können insbesondere einstückig und/oder materialeinheitlich an der Tastenkappe 21 ausgeformt sein. Die Positionierungsstifte 21s können dazu dienen, die Aktivierungselemente 24 durch Ultraschallschweißen oder Heißverstemmen an der Tastenkappe 21 zu befestigen. Ultraschallschweißen kann dabei die bevorzugte Methode darstellen, die kein Fädenziehen beim Umformen der Spitzen der Positionierungsstifte 21s verursacht. Zum Befestigen können die Aktivierungselemente 24 mit den Funktionsöffnungen 24a an den Positionierungsstiften 21s angeordnet werden, sodass die Spitzen der Aktivierungselemente 24 durch die Aktivierungselemente 24 ragen. Die Spitzen der Aktivierungselemente 24 können mithilfe von Ultraschall aufgeweicht werden und wieder erstarren, um die Aktivierungselemente 24 form- und/oder kraftschlüssig an der Innenseite 21l der Tastenkappe 21 zu befestigen.

Wie es die Figuren 4 und 5 zeigen, können an einer Innenseite 211 der Tastenkappe 21, insbesondere kreisförmige, Konturelemente 21k und/oder, insbesondere stegförmige, Stützelemente 21s zum Abstützen der Aktivierungselemente 24, vorzugsweise in einem bestimmten Abstand, zu der Tastenkappe 21 vorgesehen, insbesondere mitausgeformt, sein. Die, insbesondere stegförmigen, Stützelemente 21s können dabei als Stützrippen für die, insbesondere kreisförmigen, Konturelemente 21k ausgeführt sein. Auf diese Weise kann eine besonders stabile und zuverlässige Auflage für die Aktivierungselemente 24 an der Tastenkappe geschaffen werden.

Wie es die Figuren 3 und 5 andeuten, kann an der Tastenkappe 21, insbesondere an einer Innenseite 21I der Tastenkappe 21, mindestens eine Streustruktur 21B vorgesehen, insbesondere mitausgeformt sein, um ein Licht von der mindestens einen Leuchteinheit 33 zu streuen, zu lenken und/oder auszurichten. Somit kann das Licht auf eine verbesserte Weise verteilt und in eine Richtung zu einer Griffmulde 201M am beweglichen Teil 201 des Fahrzeuges 200 gelenkt werden.

Ferner verdeutlicht die Figur 4, dass die Tastenkappe 21 derart, insbesondere von einer Außenseite 10A des Trägergehäuses 10, am Trägergehäuse 10 abgestützt ist, insbesondere soweit erforderlich bewegbar relativ zum Trägergehäuse 10, und dass die Elektronikeinheit 30 derart, insbesondere von einer Innenseite 10I des Trägergehäuses 10, am Trägergehäuse 10 befestigt ist, insbesondere unbewegbar relativ zum Trägergehäuse 10, dass zwischen der Tastenkappe 21 und der Elektronikeinheit 30 eine Luftkammer K ausgebildet ist. Vorteilhafterweise kann die Luftkammer K durch die Anbringung einerseits der Tastenkappe 21 und andererseits der Elektronikeinheit 30 am Trägergehäuse 10 abgeschlossen und zugleich abgedichtet werden. Zum Abdichten der Luftkammer K kann ein die Tastenkappe 21 umfangsseitig umlaufendes, insbesondere balgförmiges, Dichtungselement 22 dienen. In der Luftkammer K können die Sensoreinheiten 31, 32 und die Aktivierungselemente 24 geschützt angeordnet werden.

Weiterhin deutet die Figur 3 an, dass die Elektronikeinheit 30 mindestens eine, vorzugsweise zwei, oder mehrere Leuchteinheiten 33 zum Durchleuchten der Tastenkappe 21 aufweisen kann. Mithilfe von Leuchteinheiten 33 kann die Tastenkappe 21 hinterleuchtet werden, um die Auffindbarkeit der Tastenkappe 21 zu erleichtern. Die Leuchteinheit 33 kann dabei ein Licht, bspw. sichtbares Licht, in die Luftkammer K ausstrahlen, welches die Tastenkappe 21 durchleuchten kann. Wie es in der Figur 3 erkennbar ist, kann die mindestens eine Leuchteinheit 33 mindestens ein, vorzugsweise zwei, oder mehrere Leuchtelemente, bspw. in Form von LED-Elementen, aufweisen. Die Aktivierungselemente 24 können dabei derart seitlich versetzt zu den Leuchtelementen 33 angeordnet sein, dass die Aktivierungselemente 24 die Leuchtelemente 33 möglichst nicht abschirmen.

Des Weiteren deutet die Figur 4 an, dass die Tastenkappe 21, insbesondere zumindest in einer unbetätigten Stellung, derart am Trägergehäuse 10 abgestützt sein kann, dass sich eine Außenseite 21A der Tastenkappe 21 im Wesentlichen flächenbündig zu bzw. leicht hervorstehend, bspw. im Bereich von wenigen Mikrometern bis zu wenigen Millimetern, von einer Außenseite 10A des Trägergehäuses 10 erstreckt.

Zudem zeigt die Figur 4, dass die Tastenkappe 21, insbesondere zumindest in einer unbetätigten Stellung, derart an dem Trägergehäuse 10 abgestützt sein kann, dass zwischen einer Außenseite 21A der Tastenkappe 21 und einer Außenseite 10A des Trägergehäuses 10 umfangsseitig der Tastenkappe 21 ein umlaufender Spalt S ausgebildet ist (vgl. außerdem die Figur 3). Der Bereich des umlaufenden Spalts S kann durch ein, insbesondere balgförmiges, Dichtungselement 22 ausgefüllt sein, um eine Öffnung 11 im Trägergehäuse 10 zur Luftkammer K hin abzudichten.

Bei der induktiven Sensoreinheit 31 können mindestens zwei oder mehrere, insbesondere symmetrisch an der Elektronikeinheit 30 verteilte, induktive Sensorelemente, bspw. in Form von LDC-Sensoren, angeordnet werden. Die Anzahl der induktiven Sensorelemente kann an die Anzahl der Aktivierungselemente 24 angepasst sein. In dem dargestellten Beispiel in den Figuren 3 und 4 sind zwei Aktivierungselemente 24 und zwei darunterliegende Sensorelemente angedeutet.

Darüber hinaus zeigt die Figur 3, dass die Elektronikeinheit 30 eine kapazitive Sensoreinheit 32 für eine Präsenzerfassung an der Tasteneinheit 20 aufweisen kann. Die Sensoreinheit 32 kann mehrere kapazitive Sensorelemente aufweisen, die verteilt über die Elektronikeinheit 30 an dieser angeordnet sein können. Zudem kann die kapazitive Sensoreinheit 32 eine kapazitive Auswerteinheit aufweisen, die ebenfalls an der Elektronikeinheit 30 angeordnet sein kann. Die kapazitive Sensoreinheit 32 kann zur Erfassung einer Annäherung eines Benutzers an das Modulbauteil 100 dienen.

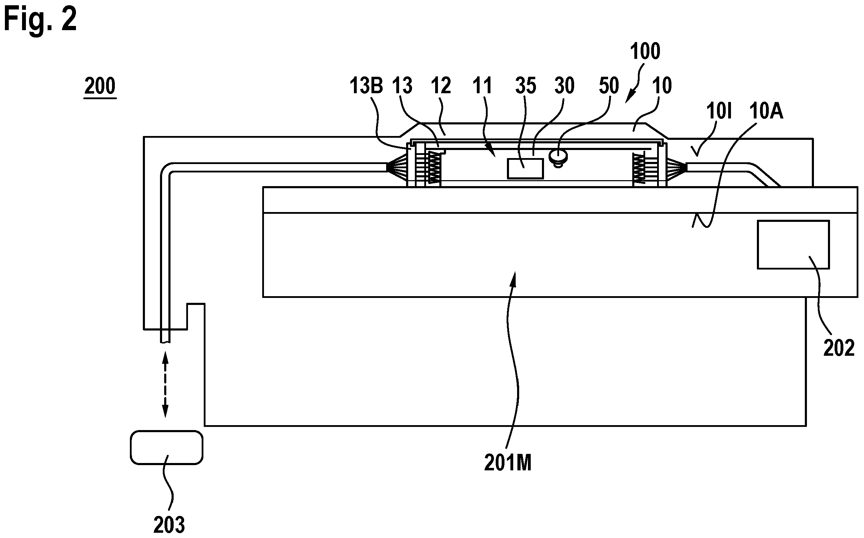

Ferner deutet die Figur 2 an, dass die Elektronikeinheit 30 eine Steuereinheit 35 aufweisen kann, mithilfe welcher die vorteilhaften Funktionen eines Zugangssystems zum Fahrzeug 200, bspw. in Form eines Keyless-Go- und/oder eines Keyless-Entry-Systems, bereitgestellt werden können. Die Steuereinheit 35 kann vorteilhafterweise mit einem Steuergerät 203 oder direkt mit einem Schließsystem des Fahrzeuges 200 funktionstechnisch verbunden sein. Zum Zweck einer Identifikationsüberprüfung kann die Steuereinheit 35 mit einer fahrzeugseitigen Kommunikationseinheit 202, bspw. in Form einer Funkeinheit oder einer NFC-Einheit, funktionstechnisch verbunden sein, um eine Berechtigung des Benutzers zu verifizieren.

Die Steuereinheit 35 kann dazu ausgeführt sein, eine Präsenzerfassung des Benutzers durch eine kapazitive Sensoreinheit 32 zu erfassen. Ferner kann die Steuereinheit 35 dazu ausgeführt sein, vorzugsweise nach einer positiven Präsenzerfassung des Benutzers, die fahrzeugseitige Kommunikationseinheit 202 zu verlassen, um eine Identifikationsüberprüfung zwischen der fahrzeugseitigen Kommunikationseinheit 202 und einem ID-Geber durchzuführen. Weiterhin kann die Steuereinheit 35 dazu ausgeführt sein, vorzugsweise nach einer positiven Präsenzerfassung und/oder einer positiven Identifikationsüberprüfung des Benutzers, eine Beleuchtung der Tastenkappe 21 einzuschalten, um ein Auffinden der Tastenkappe 21 zu erleichtern. Des Weiteren kann die Steuereinheit 35 dazu ausgeführt sein, nach einer positiven Identifikationsüberprüfung, eine Aktivierungshandlung des Benutzers an der Tastenkappe 21 durch mindestens eine induktive Sensoreinheit 31 zu erfassen. Nach einer positiven Aktivierungshandlungserfassung des Benutzers an der Tastenkappe 21 kann die Steuereinheit 35 ein fahrzeugseitiges Steuergerät 203 oder direkt ein fahrzeugseitiges Schließsystem veranlassen, das bewegliche Teil 201 des Fahrzeuges 200 entsprechend der Aktivierungshandlung zu betätigen.

Wie es die Figuren 4 bis 6 verdeutlichen, kann am Trägergehäuse 10 eine Öffnung 11 für die Tasteneinheit 20 vorgesehen sein, durch welche vorteilhafterweise eine induktive Erfassung einer Aktivierungshandlung erfolgen kann. Für einen vereinfachten Zusammenbau des Modulbauteils, kann das Trägergehäuse 10 einen wannenförmigen Sitz 12 für die Tasteneinheit 20 aufweisen. Dabei kann die Öffnung 11 an einem Boden des wannenförmigen Sitzes 12 ausgebildet sein. Die Tastenkappe 21 kann mithilfe von einem Dichtungselement 22, von einer Außenseite 10A des Trägergehäuses 10 am Trägergehäuse 10, insbesondere an einer Öffnung 11 im Trägergehäuse 10, befestigt werden.

Durch ein leichtes Eindrücken der Tastenkappe 21 kann eine Aktivierungshandlung eines Benutzers aufgenommen werden.

Vorteilhafterweise kann mindestens ein verformbarer Deformationsbereich an der Tastenkappe 21 bereitgestellt werden, um eine Aktivierungshandlung eines Benutzers aufnehmen zu können.

Optional kann für einen Druckausgleich in der Luftkammer K ein Entlüftungselement 50 vorgesehen sein (vgl. die Figur 2).

Ferner zeigen die Figuren 2 und 4 bis 6, dass das Trägergehäuse 10, insbesondere an einer Innenseite 10I, eine Rahmenstruktur 13 für die Elektronikeinheit 30 aufweisen kann, wobei insbesondere die Rahmenstruktur 13 die Öffnung 11 und insbesondere die Tasteneinheit 20 umfangsseitig umschließen und insbesondere als eine Vergusswanne zum Vergießen der Elektronikeinheit 30 dienen kann. Links in den Figuren 2, 4, 5 und 6 ist ferner eine Kabelführung 13B schematisch angedeutet, die eine einfache Verschaltung der Elektronikeinheit 30 mit einem fahrzeugseitigen Steuergerät 203 ermöglichen kann.

Wie es die Figur 2 andeutet, kann die Elektronikeinheit 30 von einer Innenseite 10I des Trägergehäuses 10 am Trägergehäuse 10, insbesondere an einer Öffnung 11 im Trägergehäuse 10, vorzugsweise hinter der Tastenkappe 21, angeordnet und/oder mit einer Vergussmasse vergossen sein, um die Elektronikeinheit 30 zu befestigen und/oder abzudichten.

Das Trägergehäuse 10 kann in Form eines Spritzgussbauteils bereitgestellt werden, bspw. aus einem formstabilen Material, insbesondere Kunststoff, vorzugsweise Hartplastik. Die Tastenkappe 20 kann ebenfalls ein formstabiles Material, insbesondere Kunststoff, vorzugsweise Polymer, bevorzugt Polyamid, aufweisen. Das Material der Tastenkappe 20 kann vorzugsweise durchsichtig sein, gemeint ist für das Licht im sichtbaren Spektrum oder zumindest für das Licht im Lichtspektrum der mindestens einen Leuchteinheit 33.

Wie oben bereits erwähnt, kann an der Tastenkappe 21 ein, insbesondere balgförmiges, Dichtungselement 22 angeordnet sein (vgl. die Figur 4), um eine Öffnung 11 im Trägergehäuse 10 abzudichten und insbesondere die Sensoreinheiten 31, 32 und die Aktivierungselemente 24 vor Witterungseinflüssen zu schützen. Das Dichtungselement 22 kann die Tastenkappe 21 umranden und abdichtend an der Öffnung 11 im Trägergehäuse 10 zur Auflage kommen. Ein überstehender Rand des Dichtungselementes 22 kann dazu ausgeführt sein, die Tastenkappe 21 am Trägergehäuse 10, bevorzugt an einer Öffnung 11 im Trägergehäuse 10, insbesondere durch ein Laserschweißverfahren, zu befestigen.

Das Dichtungselement 22 kann ein elastisches Material, insbesondere Kunststoff, vorzugsweise Elastomer, bevorzugt thermoplastischen Elastomer, aufweisen.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 200: Fahrzeug
- 201: bewegliches Teil
- 201M: Griffmulde
- 202: Kommunikationseinheit
- 203: Steuergerät

- 100: Modulbauteil

- 10: Trägergehäuse
- 10A: Außenseite
- 10I: Innenseite
- 11: Öffnung
- 12: Sitz
- 13: Rahmenstruktur
- 13B: Kabelführung

- 20: Tasteneinheit

- 21: Tastenkappe
- 21A: Außenseite
- 21l: Innenseite
- 21k: Konturelement
- 21r: Stützelemente
- 21s: Positionierungsstifte
- 21B: Streustruktur

- 22: Dichtungselement
- 22b: Befestigungsbereich
- 22f: Faltbereich
- 22s: Stützbereich

- 24: Aktivierungselement
- 24a: Funktionsöffnung

- 30: Elektronikeinheit
- 31, 32: Sensoreinheit
- 31: induktive Sensoreinheit
- 32: kapazitive Sensoreinheit
- 33: Leuchteinheit
- 35: Steuereinheit

- 40: Notöffnungselement
- 50: Entlüftungselement

- B: Bus
- K: Luftkammer
- L: Licht

## Patentansprüche

1. Modulbauteil (100) für ein bewegliches Teil (201) eines Fahrzeuges (200),
aufweisend:
- ein Trägergehäuse (10) zum Befestigen des Modulbauteils (100) am beweglichen Teil (201) des Fahrzeuges (200),
- eine Tasteneinheit (20) zum Betätigen des beweglichen Teils (201) des Fahrzeuges (200),
wobei die Tasteneinheit (20) eine Tastenkappe (21) aufweist, die dazu ausgeführt ist, eine Aktivierungshandlung, insbesondere eine Berührung und/oder Kraftausübung, eines Benutzers aufnehmen zu können,
wobei an der Tastenkappe (21) zwei Aktivierungselemente (24) angeordnet sind, um die Aktivierungshandlung des Benutzers erfassen zu können,
- und eine Elektronikeinheit (30) zum Bereitstellen von Sensorfunktionen beim Betätigen des beweglichen Teils (201) des Fahrzeuges (200),
wobei die Elektronikeinheit (30) am Trägergehäuse (10) befestigt ist,
und wobei die Elektronikeinheit (30) eine induktive Sensoreinheit (31) für eine Aktivierungshandlungserfassung an der Tasteneinheit (20) aufweist.

2. Modulbauteil (100) nach Anspruch 1,
**dadurch gekennzeichnet,**
**dass** die Aktivierungselemente (24) jeweils ein elektrisch leitendes Material, insbesondere Metall, vorzugsweise Aluminium oder Kupfer, aufweisen,
und/oder dass die Aktivierungselemente (24) in Form von elektrisch leitenden Plättchen ausgeführt sind,
und/oder dass die Aktivierungselemente (24) scheibenförmig, kreisförmig und/oder trichterförmig ausgeführt sind,
und/oder dass die Aktivierungselemente (24) jeweils eine, insbesondere axial ausgebildete, Funktionsöffnung (24a) aufweisen,
und/oder dass die Tastenkappe (21) mindestens einen Deformationsbereich aufweist, um eine Aktivierungshandlung, insbesondere eine Berührung und/oder Kraftausübung, eines Benutzers aufnehmen zu können,
und/oder dass die Aktivierungselemente (24) an mindestens einem Deformationsbereich der Tastenkappe (21) angeordnet sind.

3. Modulbauteil (100) nach Anspruch 1 oder 2,
**dadurch gekennzeichnet,**
**dass** die Aktivierungselemente (24) an der Tastenkappe (21) befestigt sind, um durch eine Bewegung der Aktivierungselemente (24) relativ zu der induktiven Sensoreinheit (31) eine messbare Induktivitätsänderung in der induktiven Sensoreinheit (31) zu bewirken,
und/oder dass die Aktivierungselemente (24) derart an der Tastenkappe (21) befestigt sind, dass die Aktivierungselemente (24) beabstandet, vorzugsweise in einem bestimmten Abstand, zur induktiven Sensoreinheit (31) positioniert werden können, und/oder dass die Aktivierungselemente (24) galvanisch getrennt von der Elektronikeinheit (30) angeordnet sind,
und/oder dass die Aktivierungselemente (24) zwischen der Tastenkappe (21) und der induktiven Sensoreinheit (31) positioniert sind.

4. Modulbauteil (100) nach einem der vorhergehenden Ansprüche,
**dadurch gekennzeichnet,**
**dass** die Aktivierungselemente (24) an einer Innenseite (21l) der Tastenkappe (21) form- und/oder kraftschlüssig befestigt sind,
und/oder dass an einer Innenseite (21l) der Tastenkappe (21) Positionierungsstifte (21s) zum Positionieren und/oder Befestigen der Aktivierungselemente (24) vorgesehen, insbesondere ausgeformt, sind,
wobei insbesondere die Positionierungsstifte (21s) dazu ausgeführt sind, um die Aktivierungselemente (24) durch Ultraschallschweißen oder Heißverstemmen an der Tastenkappe (21) zu befestigen,
und/oder dass an einer Innenseite (21l) der Tastenkappe (21), insbesondere kreisförmige, Konturelemente (21k) und/oder, insbesondere stegförmige, Stützelemente (21r) zum Abstützen der Aktivierungselemente (24), vorzugsweise in einem bestimmten Abstand, zu der Tastenkappe (21) vorgesehen, insbesondere ausgeformt, sind, wobei bevorzugt die, insbesondere stegförmigen, Stützelemente (21r) als Stützrippen für die, insbesondere kreisförmigen, Konturelemente (21k) ausgeführt sind.

5. Modulbauteil (100) nach einem der vorhergehenden Ansprüche,
**dadurch gekennzeichnet,**
**dass** die Tastenkappe (21) derart, insbesondere von einer Außenseite (10A) des Trägergehäuses (10), am Trägergehäuse (10) abgestützt ist,
und **dass** die Elektronikeinheit (30) derart, insbesondere von einer Innenseite (10I) des Trägergehäuses (10), am Trägergehäuse (10) befestigt ist,
**dass** zwischen der Tastenkappe (21) und der Elektronikeinheit (30) eine Luftkammer (K) ausgebildet ist.

6. Modulbauteil (100) nach einem der vorhergehenden Ansprüche,
**dadurch gekennzeichnet,**
**dass** die Elektronikeinheit (30) mindestens eine Leuchteinheit (33) zum Durchleuchten der Tastenkappe (21) aufweist,
insbesondere wobei die mindestens eine Leuchteinheit (33) dazu ausgeführt ist, ein Licht in die Luftkammer (K) auszustrahlen, welches die Tastenkappe (21) durchleuchten kann, und/oder wobei die mindestens eine Leuchteinheit (33) mindestens ein, vorzugsweise zwei oder mehrere Leuchtelemente, bspw. in Form von LED-Elementen, aufweist, und/oder dass die Aktivierungselemente (24) mit einem seitlichen Abstand zu den Leuchtelementen positioniert sind,
und/oder dass an der Tastenkappe (21), insbesondere an einer Innenseite (21l) der Tastenkappe (21), mindestens eine Streustruktur (21B) vorgesehen, insbesondere ausgeformt ist, um ein Licht von der mindestens einen Leuchteinheit (33) zu streuen, zu lenken und/oder auszurichten.

7. Modulbauteil (100) nach einem der vorhergehenden Ansprüche,
**dadurch gekennzeichnet,**
**dass** die Tastenkappe (21), insbesondere zumindest in einer unbetätigten Stellung, derart am Trägergehäuse (10) abgestützt ist, dass sich eine Außenseite (21A) der Tastenkappe (21) im Wesentlichen flächenbündig zu oder hervorstehend von einer Außenseite (10A) des Trägergehäuses (10) erstreckt,
und/oder dass die Tastenkappe (21) , insbesondere zumindest in einer unbetätigten Stellung, derart an dem Trägergehäuse (10) abgestützt ist, dass zwischen einer Außenseite (21A) der Tastenkappe (21) und einer Außenseite (10A) des Trägergehäuses (10) umfangsseitig der Tastenkappe (21) ein umlaufender Spalt (S) ausgebildet ist,
wobei insbesondere der umlaufende Spalt (S) durch ein, insbesondere balgförmiges, Dichtungselement (22) ausgefüllt ist, um eine Öffnung (11) im Trägergehäuse (10) abzudichten und insbesondere die Sensoreinheiten (31, 32) und/oder die Aktivierungselemente (24) vor Witterungseinflüssen zu schützen.

8. Modulbauteil (100) nach einem der vorhergehenden Ansprüche,
**dadurch gekennzeichnet,**
**dass** die induktive Sensoreinheit (31) zwei induktive Sensorelemente, bspw. in Form von LDC-Sensoren, für die Aktivierungshandlungserfassung an der Tasteneinheit (20) aufweist,
und/oder dass die Elektronikeinheit (30) eine kapazitive Sensoreinheit (32) für eine Präsenzerfassung an der Tasteneinheit (20) aufweist, die insbesondere ein oder mehrere kapazitive(s) Sensorelement(e) und/oder eine kapazitive Auswerteinheit aufweist.

9. Modulbauteil (100) nach einem der vorhergehenden Ansprüche,
**dadurch gekennzeichnet,**
**dass** die Elektronikeinheit (30) eine Steuereinheit (35) aufweist,
wobei insbesondere die Steuereinheit (35) mit mindestens einer fahrzeugseitigen Kommunikationseinheit (202), insbesondere in Form einer Funkeinheit und/oder einer NFC-Einheit, in eine Kommunikationsverbindung bringbar ist, die mit einem mobilen ID-Geber eines Benutzers in eine Signalverbindung bringbar ist, um eine Identifikationsüberprüfung des Benutzers durchzuführen,
wobei vorzugsweise die Steuereinheit (35) mit einem fahrzeugseitigen Steuergerät (203) und/oder einem fahrzeugseitigen Schließsystem in eine Kommunikationsverbindung bringbar ist, um ein Betätigen des beweglichen Teils (201) des Fahrzeuges (200) einzuleiten.

10. Modulbauteil (100) nach dem vorhergehenden Anspruch,
**dadurch gekennzeichnet,**
**dass** die Steuereinheit (35) dazu ausgeführt ist, eine Präsenzerfassung eines Benutzers durch eine kapazitive Sensoreinheit (32) zu erfassen,
und/oder dass die Steuereinheit (35) dazu ausgeführt ist, vorzugsweise nach einer positiven Präsenzerfassung eines Benutzers, eine fahrzeugseitige Kommunikationseinheit (202) zu veranlassen, um eine Identifikationsüberprüfung zwischen der fahrzeugseitigen Kommunikationseinheit (202) und einem ID-Geber des Benutzers durchzuführen,
und/oder dass die Steuereinheit (35) dazu ausgeführt ist, vorzugsweise nach einer positiven Identifikationsüberprüfung, eine Aktivierungshandlung eines Benutzers an den Aktivierungselementen (24) durch induktive Sensoreinheiten (31) zu erfassen, und/oder dass die Steuereinheit (35) dazu ausgeführt ist, vorzugsweise nach einer positiven Präsenzerfassung und/oder einer positiven Identifikationsüberprüfung des Benutzers, eine Beleuchtung der Tastenkappe (21) einzuschalten, um ein Auffinden der Tastenkappe (21) zu erleichtern.

11. Modulbauteil (100) nach einem der vorhergehenden Ansprüche,
**dadurch gekennzeichnet,**
**dass** das Trägergehäuse (10) eine Öffnung (11) für die Tasteneinheit (20) aufweist, und/oder dass das Trägergehäuse (10) einen wannenförmigen Sitz (12) für die Tasteneinheit (20) aufweist,
wobei insbesondere die Öffnung (11) an einem Boden des wannenförmigen Sitzes (12) am Trägergehäuse (10) für die Tasteneinheit (20) ausgebildet ist,
und/oder dass die Tastenkappe (21), vorzugsweise mithilfe von einem Dichtungselement (22), von einer Außenseite (10A) des Trägergehäuses (10) am Trägergehäuse (10), insbesondere an einer Öffnung (11) im Trägergehäuse (10), befestigt ist.

12. Modulbauteil (100) nach einem der vorhergehenden Ansprüche,
**dadurch gekennzeichnet,**
**dass** das Trägergehäuse (10), insbesondere an einer Innenseite (10l), eine Rahmenstruktur (13) für die Elektronikeinheit (30) aufweist,
wobei insbesondere die Rahmenstruktur (13) die Öffnung (11) und insbesondere die Tasteneinheit (20) umfangsseitig umschließt und insbesondere als eine Vergusswanne zum Vergießen der Elektronikeinheit (30) dient,
und/oder dass die Elektronikeinheit (30) von einer Innenseite (10l) des Trägergehäuses (10) am Trägergehäuse (10), insbesondere an einer Öffnung (11) im Trägergehäuse (10), vorzugsweise hinter der Tastenkappe (21), angeordnet und/oder mit einer Vergussmasse vergossen ist, um die Elektronikeinheit (30) zu befestigen und/oder abzudichten.

13. Modulbauteil (100) nach einem der vorhergehenden Ansprüche,
**dadurch gekennzeichnet,**
**dass** das Trägergehäuse (10) ein Spritzgussbauteil ist,
und/oder dass das Trägergehäuse (10) ein formstabiles Material, insbesondere Kunststoff, vorzugsweise Hartplastik, aufweist,
und/oder dass die Tastenkappe (21) ein formstabiles und/oder durchsichtiges Material, insbesondere Kunststoff, vorzugsweise Polymer, bevorzugt Polyamid, aufweist.

14. Modulbauteil (100) nach einem der vorhergehenden Ansprüche,
**dadurch gekennzeichnet,**
**dass** an der Tastenkappe (21) ein, insbesondere balgförmiges, Dichtungselement (22) angeordnet ist, um eine Öffnung (11) im Trägergehäuse (10) abzudichten und insbesondere die Sensoreinheiten (31, 32) und die Aktivierungselemente (24) vor Witterungseinflüssen zu schützen,
insbesondere wobei das Dichtungselement (22) dazu ausgeführt ist, die Tastenkappe (21) am Trägergehäuse (10), bevorzugt an einer Öffnung (11) im Trägergehäuse (10), insbesondere durch ein Laserschweißverfahren, zu befestigen und/oder wobei das Dichtungselement (22) ein elastisches Material, insbesondere Kunststoff, vorzugsweise Elastomer, bevorzugt thermoplastischen Elastomer, aufweist.

15. Verfahren zum Herstellen eines Modulbauteils (100) nach einem der vorhergehenden Ansprüche für ein bewegliches Teil (201) eines Fahrzeuges (200),
aufweisend:
- Bereitstellen eines Trägergehäuses (10) zum Befestigen des Modulbauteils (100) am beweglichen Teil (201) des Fahrzeuges (200),
- Bereitstellen einer Tasteneinheit (20) zum Betätigen des beweglichen Teils (201) des Fahrzeuges (200) mit einer Tastenkappe (21) und zwei Aktivierungselementen (24),
- Abstützen der Tastenkappe (21), insbesondere von außen, am Trägergehäuse (10) zum Aufnehmen einer Aktivierungshandlung, insbesondere einer Berührung und/oder einer Kraftausübung, eines Benutzers,
- Befestigen der Aktivierungselemente (24), insbesondere von innen, an der Tastenkappe (21),
- Bereitstellen einer Elektronikeinheit (30) zum Bereitstellen von Sensorfunktionen beim Betätigen des beweglichen Teils (201) des Fahrzeuges (200) mit einer induktiven Sensoreinheit (31) für eine Aktivierungshandlungserfassung an der Tasteneinheit (20),
- Befestigen einer Elektronikeinheit (30), insbesondere von innen, am Trägergehäuse (10).
